# EUROPEAN PATENT APPLICATION

(11) **EP 4 257 250 A1**
(43) Date of publication of application: **11.10.2023**
(21) Application number: 22167028.4
(22) Date of filing: 06.04.2022
(51) Int. Cl.: B05D 1/00, C23C 16/448, C23C 16/455, C23C 16/513, B05B 7/00, B05B 7/24, B05B 14/00, B05D 1/02, B05D 1/34

(54) **IMPROVED ATOMIZER FOR PLASMA COATING APPARATUS**

(71) Applicant: Molecular Plasma Group S.A., 3895 Foetz (LU)
(72) Inventor: HEYBERGER, Régis, F-57100 Thionville (FR); SCHONS, Bertrand, F-57190 Florange (FR); BOREK-DONTEN, Joanna, B-6700 Arlon (BE)
(74) Representative: IPLodge bv

(57) **Abstract**

The present invention concerns an aerosol generating device for generating a precursor-comprising aerosol flow for a plasma coating process, the aerosol generating device comprising an aerosol droplet separator and a set of atomizing compartments, whereby the aerosol droplet separator comprises a nozzle outlet, a precursor recycling outlet and an aerosol channel therebetween, and whereby each atomizing compartment comprises: - a fluid flow channel comprising an atomizer gas flow inlet and an atomizer gas flow outlet fluidly connected to the aerosol channel; - a precursor channel comprising a precursor channel inlet and a precursor channel outlet, the precursor channel outlet fluidly connected to the fluid flow channel for introducing precursor droplets into a gas flow in the fluid flow channel; - a precursor reservoir for a liquid precursor the precursor reservoir in fluid connection with the precursor channel inlet; - a droplet introduction means located at or near the precursor channel outlet for introducing liquid precursor droplets from the precursor reservoir via the precursor channel into a gas flow in the fluid flow channel; - a dilution flow channel separated from the fluid flow channel, the dilution flow channel comprising a dilution flow inlet and a dilution flow outlet fluidly connected to the aerosol channel, whereby for each atomizing compartment, the dilution flow outlet is located between the atomizer gas flow outlet and the nozzle outlet of the aerosol droplet separator.

## Description

### Technical field

The present invention relates to an improved atomizer for a plasma coating apparatus and an improved method for atomizing a liquid for use in a plasma coating method. The present invention thus relates to the field of atomizers and to the field of plasma coating methods and apparatuses.

### Background

Plasma coating is a technique whereby a coating is deposited on a substrate using a precursor. Hereby the precursor is excited to make it more reactive such that it can more easily form a high-quality coating on the substrate. Excitation of the precursor is obtained via a plasma process, either directly of indirectly.

In a direct plasma coating process, a fluid comprising the precursor is plasmized e.g. by making the fluid flow through a set of electrodes which strike a plasma into the fluid by application of a high voltage. In such direct process, the precursor can be directly excited. The excited precursor can then be made to interact with a substrate, thereby forming a coating onto the substrate.

In an indirect plasma coating process, a process fluid, preferably a process gas, is plasmized, e.g. by making the process fluid flow between a set of electrodes which can strike a plasma in the process fluid by application of a high voltage. The plasmized process gas then leaves the plasma zone, i.e. it leaves the zone wherein plasma is actively induced, e.g. the zone between the set of electrodes. A precursor-comprising fluid is then mixed with the plasmized process gas in the plasma afterglow. The precursor is then excited within this mixture due to secondary interaction with the plasmized process gas, rendering the precursor more reactive for allowing a coating to be formed on a substrate being exposed to the mixture and the excited precursor in said mixture.

Plasma coating processes may be performed at atmospheric processes or at vacuum pressure. The current invention is particularly relevant for plasma coating processes at atmospheric pressure. In atmospheric pressure plasma coating processes, the substrate is subjected to the mixture comprising said excited precursor at essentially atmospheric pressure. This has the particular advantage that the there is no requirement for vacuum technology and that the substate can be continuously treated e.g. by moving the substrate through the mixture and/or by flowing the mixture over the substrate. This is in contract with vacuum pressure plasma coating pressure, whereby it is always a hassle to ensure low pressure at the position of the substrate's exposure to the mixture. Furthermore, atmospheric pressure plasma coating processes have the further advantage that it tends to be easier to transport many different types of precursors to the plasma zone and/or the plasma afterglow region.

The present invention is preferably situated in the field of indirect atmospheric pressure plasma coating processes. Furthermore, the present invention is also preferably situated in the field of low temperature plasma coating processes, whereby the temperature of the plasma and the temperature of the mixture comprising the excited precursor typically lower is than 200°C, and preferably around room temperature. This already sets a severe constraint on the method for transporting the precursor: if the precursor is vaporized in order to be easily mixed with the plasmized process gas, the mixture may have a high temperature, depending on a number of factors such as the vaporization temperature of the precursor and the flow rates of the process gas and the vaporized precursor. For many precursors, and in particular for high-mass precursors, the vaporization temperature may be very high, such that the temperature of the mixture is high. In such cases, the substrate may actually be affected by the high temperature, e.g. certain polymer substrates may melt, deformation due to the temperature gradients may occur, the coating may not stick to the substrate after cooling, etc. In order to overcome this problem, the precursor can be transported to the process gas in the form of an aerosol.

Within the context of the present invention, an aerosol is a suspension of fine liquid droplets in gas. The aerosol behaves as a fluid. The diameter of the droplets may vary, but typically is about 1µm or less. The process of suspending liquid droplets in a gas flow is also called atomization.

The present invention relates to an improved atomizer for atomizing a liquid precursor for an atmospheric pressure, low-temperature plasma coating process, as well as to an improved method of atomizing a liquid precursor for said plasma coating process.

An exemplary known atomizer is, for instance, the Aerosol Generator Model 3076 from TSI Inc. This atomizer allows generation of an aerosol using an aerosol gas flow into which droplets can be suspended of a liquid precursor from a reservoir, using the Venturi effect. However, the inventors have found that such an atomizer may not allow good control of the droplet size, the droplet concentration in the aerosol and/or the precursor concentration in the aerosol for further use in a plasma coating apparatus or plasma coating process. More in particular, the conditions with respect to flow rates, pressure gradients, temperatures, etc. which are most efficient to generate the aerosol, may not be compatible with the required conditions of the aerosol for use in a further plasma coating apparatus or method.

Furthermore, in some plasma coating processes, one prefers to use a precursor comprising two or more different substances. In such cases, it may be difficult to control the absolute and/or relative abundance of the different substances in the aerosol. For instance, if the liquid precursor in the reservoir comprises two substances in equal concentration (i.e. 50 wt% of a first substance and 50 wt% of a second substance), this equal concentration may not be preserved in the aerosol because the different substances may be atomized differently. Further, the efficiency of the atomization may drop considerably due to large difference in optimal atomization parameters for the different substances.

The present inventors therefor have developed an improved atomizer and an improved atomizing method for generating a precursor-comprising aerosol for an indirect atmospheric pressure, low-temperature plasma coating process. The improved atomizer allows good control over the precursor-comprising aerosol flow, and allows easy modifications to the precursor-comprising aerosol flow in case one has to modify its parameters, e.g. for testing purposes or for quick changes in the precursor-comprising aerosol which can be required by the plasma coating process.

The atomizer and atomizing method of the present invention further allows better control over the amount of precursor in the resulting aerosol flow, in particular over the size of the droplets, the concentration of droplets and/or the concentration of precursor in the resulting aerosol flow. The present invention also allows easy scaling of the total quantity of the precursor and/or precursor droplets in the aerosol flow. Furthermore, the present invention also allows generation of a precursor-comprising aerosol whereby the precursor comprises two or more substances.

### Summary of the invention

The present invention concerns an aerosol generating device for generating a precursor-comprising aerosol flow for a plasma coating process, the aerosol generating device comprising an aerosol droplet separator and a set of atomizing compartments,
whereby the aerosol droplet separator comprises a nozzle outlet, a precursor recycling outlet and an aerosol channel therebetween,
and whereby each atomizing compartment comprises:
   - a fluid flow channel comprising an atomizer gas flow inlet, preferably connected to an atomizing gas supply, and an atomizer gas flow outlet fluidly connected to the aerosol channel;
   - a precursor channel comprising a precursor channel inlet and a precursor channel outlet, the precursor channel outlet fluidly connected to the fluid flow channel for introducing precursor droplets into a gas flow in the fluid flow channel;
   - a precursor reservoir for a liquid precursor, preferably comprising the liquid precursor, the precursor reservoir in fluid connection with the precursor channel inlet;
   - a droplet introduction means located at or near the precursor channel outlet for introducing liquid precursor droplets from the precursor reservoir via the precursor channel into a gas flow in the fluid flow channel;
   - a dilution flow channel separated from the fluid flow channel, the dilution flow channel comprising a dilution flow inlet, preferably connected to a dilution gas supply, and a dilution flow outlet fluidly connected to the aerosol channel,
whereby for each atomizing compartment, the dilution flow outlet is located between the atomizer gas flow outlet and the nozzle outlet of the aerosol droplet separator.

Preferably the dilution flow channel is oriented essentially parallel to the fluid flow channel. Also preferably, the aerosol channel is oriented essentially perpendicular to the fluid flow channel and/or the dilution flow channel.

The dilution flow channel allows to control the amount and/or size of droplets in the aerosol in a precise and stable manner, and independent of how the precursor is introduced in the fluid flow channel. For many applications, the dilution flow outlet is located relatively close to the atomizer gas flow outlet in order to better control the amount and size of the droplets. Hence, in a preferred embodiment, the dilution flow outlet is located within an inter-outlet distance of 10cm or less from the atomizer gas flow outlet, such as 10 cm, 9 cm, 8 cm, 7 cm, 6 cm, 5 cm, 4 cm, 3 cm, 2cm, 1cm or any value therebetween or below. The control on the amount and/or size of droplets can be achieved through fluid dynamics processes. Hereby, the dilution flow can be controlled in order to hydrodynamically regulate the pressure, pressure gradients and/or flow within the aerosol channel, and accordingly regulate the droplet size and/or amount in the aerosol flowing in the aerosol channel. As such, more freedom can be obtained in the selection of the parameters which are important to efficiently atomize the precursor in the gas flow in the fluid flow channel, such as the atomizer gas flow, atomizing gas pressure, atomizing gas temperature, precursor reservoir pressure, precursor reservoir temperature, etc. The dilution flow thus creates the aerosol flow which can be guided to a plasma coating apparatus via a nozzle attached to the nozzle outlet of the aerosol droplet separator. The droplets which are not taken up in this aerosol flow can be removed from the aerosol channel via the precursor recycling outlet. This removal is achieved by the dilution flow, and may preferably be achieved by gravitation, i.e. in this case the precursor recycling outlet is located lower than the nozzle outlet such that the droplets which are not taken up in the aerosol flow can flow down along the walls of the aerosol channel to where they can be recycled.

The droplet introduction means preferably comprises a Venturi tube located in the fluid flow channel at the location of the precursor channel outlet. This allows introduction of precursor droplets in the atomizer gas flow due to the Venturi effect. For instance, the fluid flow channel may comprise a cross section which narrows near and/or at the location of the precursor channel outlet, i.e. where the precursor channel is fluidly connected to the fluid flow channel.

In an embodiment, the set of atomizing compartments comprises one compartment. However, a particular advantage of the present invention is that the atomizing compartments can be easily parallelized. Indeed, in an embodiment, the set of atomizing compartments comprises more than one atomizing compartment, such as 2, 3, 4, 5, 6, 7, 8, 9, 10, 11, 12, 13, 14, 15, 16, 17, 18, 19, 20 or more atomizing compartments. The multiple atomizing compartments can be arranged next to one another thereby forming a row of atomizing compartments. Hereby, the atomizer gas flow outlets of each of the atomizing compartments of the set are fluidly connected to the same aerosol channel. This allows the aerosols coming from the multiple atomizing compartments to be guided jointly to the plasma coating apparatus.

The parallelization of the atomizing compartments provides two important advantages. Firstly, it allows to increase the total flow of aerosol which can be delivered to a plasma coating apparatus. And secondly, it allows to combine the flow from the multiple atomizing compartments in the event of multiple precursors used, i.e. if the plasma coating apparatus is to be provided with a mixture of different precursors, multiple atomizing compartments connected to the aerosol channel in parallel allows a continuous supply of aerosol comprising a combination of different precursors. Moreover, since the atomizing components have a separate fluid flow channel, the parameters of the fluid flow channel such as the flow of the plasma gas through the fluid flow channel, or even the dimensions of the channel, can be selected and/or regulated in order to efficiently atomize the specific precursor within that atomizing comportment. Hence, in a preferred embodiment, each atomizing component comprises an atomizer control system for controlling the atomizing parameters. The atomizing parameters may comprise any or any of the following:
- flow of plasma gas through the fluid flow channel;
- temperature of the plasma gas in the fluid flow channel;
- temperature of the precursor in the reservoir and/or in the precursor channel;
- pressure in the precursor reservoir and/or precursor channel.

This allows to separately control the parameters of the atomizing process in each of the atomizing compartments and thus to optimize the atomizing process for each atomizing compartment separately and/or in function of the required precursor demand for the plasma coating apparatus.

In a similar aspect, the present invention concerns an aerosol generating method for generating a precursor-comprising aerosol flow for a plasma coating process, the method comprising the steps of:
- providing an atomizer gas flow in a fluid flow channel;
- introducing droplets of a precursor from a precursor reservoir in said atomizer gas flow, thereby creating a precursor-comprising aerosol flow in the fluid flow channel;
- guiding said aerosol flow to an aerosol channel via a fluid flow channel outlet;
- guiding a dilution flow into said aerosol channel via a dilution flow outlet, thereby hydrodynamically regulating size and/or quantity of droplets in the aerosol flow and leading to precursor residue separated from the aerosol flow;
- guiding the aerosol flow in the aerosol channel to a nozzle outlet and guiding the precursor residue to a precursor recycling outlet.

Preferably the precursor-comprising aerosol flow is additionally guided to a plasma coating apparatus via a nozzle attached to the nozzle outlet.

The present invention also concerns a plasma coating system comprising the aerosol generating device according to the present invention and a plasma coating apparatus, whereby the aerosol channel of the aerosol generating device is fluidly connected to a precursor input of the plasma coating apparatus by a nozzle connected between the nozzle outlet of the aerosol channel and the nozzle inlet of the plasma coating apparatus. Accordingly, the present invention also concerns a method of plasma coating a substrate using a method according as described here above, comprising the further steps of guiding the aerosol flow from the aerosol channel to a plasma coating apparatus and plasma coating the substrate with said aerosol flow using the plasma coating apparatus.

A plasma coating apparatus as well as a plasma coating process using a precursor-comprising aerosol is known in the art from e.g. patent documents WO2021123414A1, EP3881941A1, WO2019243631A1, WO2020099434A1 and/or WO2019038378A1 in name of the current applicant.

### Overview of the figures

**Figure 1** illustrates an atomizer using the Venturi effect
**Figure 2A** illustrates a aerosol generating device (1) according to the present invention in a cross sectional view. **Figure 2B** shows a perspective view on the internal of a device according to the present invention.
**Figures 3A** **and** **3B** illustrate the aerosol generating device comprising a nozzle.
**Figure 4** illustrates how the aerosol generating device can coupled to a plasma coating apparatus (25) using a nozzle.
**Figures 5A and 5B** illustrate two possible embodiments of a plasma coating device which can be used.

### Detailed description of the invention

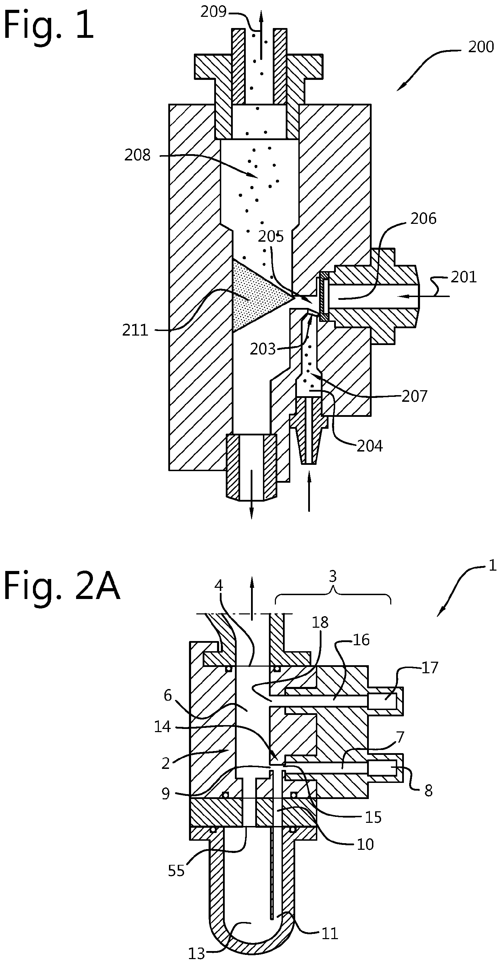

Figure 1 illustrates an atomizer using the Venturi effect. The shown atomizer (200) comprises an atomizer gas flow inlet (201) through which a gas, preferably a plasma gas, can be made to flow. A reservoir comprising a liquid substance, preferably comprising the precursor, can be connected to a precursor inlet (202). The precursor inlet comprises a precursor channel (204) which is fluidly connected (203) to the gas inlet. The gas inlet comprises a gas inlet channel (206) having a cross section which preferably comprises a narrowing (205) towards and near the fluid connection (203) with the precursor channel (204). The narrowing ensures a rapid gas flow and thereby a static underpressure for creating the Venturi effect. Hereby, small-sized precursor droplets (207) and precursor molecules can basically be sucked out of the reservoir due to the underpressure, thereby forming part of the flow in an aerosol channel (211). A portion of the precursor droplets (208) can mix with the gas, thereby forming an aerosol, and can be transported (209) to the plasma zone or plasma afterglow. Another portion of the droplets may not mix with the gas and/or may condense (211), e.g. against a wall in the aerosol channel, and can be transported to an excess liquid drain (210), where it may be recuperated for further use.

Figure 2A illustrates a aerosol generating device (1) according to the present invention in a cross sectional view. The device comprises an aerosol droplet separator (2) and an atomizing compartment (3). The aerosol droplet separator comprises a nozzle outlet (4), a precursor recycling outlet (5) and an aerosol channel (6) therebetween.

The atomizing compartment (3) comprises:
- a fluid flow channel (7) comprising an atomizer gas flow inlet (8), preferably connected to an atomizing gas supply, and an atomizer gas flow outlet (9) fluidly connected to the aerosol channel (6);
- a precursor channel (10) comprising a precursor channel inlet (11) and a precursor channel outlet (12), the precursor channel outlet (12) fluidly connected to the fluid flow channel (7) for introducing precursor droplets into a gas flow in the fluid flow channel;
- a precursor reservoir (13) for a liquid precursor, preferably comprising the liquid precursor, the precursor reservoir (13) in fluid connection with the precursor channel inlet (11);
- a droplet introduction means (14) located at or near the precursor channel outlet (12) for introducing liquid precursor droplets from the precursor reservoir (13) via the precursor channel (10) into a gas flow in the fluid flow channel. The droplet introduction means comprises a Venturi tube (15) located in the fluid flow channel (7) at the location of the precursor channel outlet (12).
- a dilution flow channel (16) separated from the fluid flow channel (7), the dilution flow channel (16) comprising a dilution flow inlet (17), preferably connected to a dilution gas supply, and a dilution flow outlet (18) fluidly connected to the aerosol channel (6).

Hereby, the dilution flow outlet is located between the atomizer gas flow outlet (9) and the nozzle outlet (4) of the aerosol droplet separator (2).

Note that, due to the cross-sectional view of fig. 2A, other atomizing compartments are not shown, but can be present in the direction perpendicular to the plane of the cross sectional view, i.e. the atomizing compartment (3) shown in fig. 2A can be repeated multiple times in the direction perpendicular to the plane of the cross sectional view. Hereby the aerosol droplet separator preferably comprises an essentially constant cross section in the direction perpendicular to the plane of the shown cross section, i.e. whereas the atomizing compartment can be repeated multiple times with separate fluid flow channels, separate dilution channels, separate precursor channels and/or separate precursor reservoirs, the aerosol channel preferably extends across all the atomizing compartments.

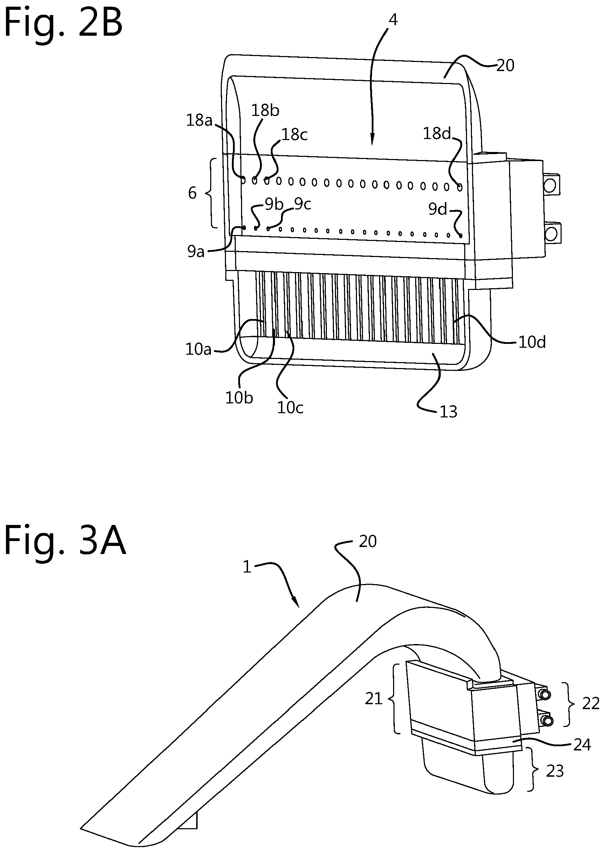

To illustrate the above, fig. 2B shows a perspective view on the internal of a device according to the present invention with a set of 20 parallelized atomizing compartments. Hereby the device is cut through the aerosol channel (6) and shows the dilution flow outlets (18a, 18b, 18c, 18d), the fluid flow channel outlets (9a, 9b, 9c, 9d) and the precursor channels (10a, 10b, 10c, 10d) of the atomizing compartments. Note that only 4 of the dilution flow outlets, the fluid flow channel outlets and precursor channels are referenced in order not to clutter the figure with too many references. The figure also shows the precursor reservoir (13), which in the shown embodiment is a common precursor reservoir for all atomizing compartments, i.e. the precursor reservoirs or the atomizing compartments are fluidly connected. Also note that the aerosol channel (6) is a single aerosol channel for all atomizing compartments in the embodiment of fig. 2B. The embodiment shown in fig. 2B is particularly preferred in case the parallelization is mainly used for increasing the total flow rate of precursor-comprising aerosol which can be generated for the plasma coating process whereby a single precursor fluid is used: the aerosols from the different atomizing compartments are then allowed to mix in the aerosol channel and the recuperation of precursor droplets can be done collectively.

Note however that in other embodiments, further compartmentalization may occur. For instance, the aerosol channel may be compartmentalized, for instance the aerosol channel may comprise two or more separate sections for two or more subsets of atomizing compartments, preferably the aerosol channel comprises a separate section for each of the atomizing compartments. Preferably, the separate sections extend from the fluid flow channel outlet up to the nozzle outlet. Additionally, or alternatively, the separate section may extend from the fluid flow channel outlet down to the precursor recycling outlet. Separate sections allow to keep the precursor flows for different atomizing compartments separate until the nozzle and/or until being recycled, which can be important e.g. in the case different precursors are used in different atomizing compartments.

Compartmentalization can also be used to better control the atomization processes in the atomizing compartments.

In an embodiment, the precursor reservoirs of two or more atomizing compartments may be fluidly connected. In a preferred embodiment, the precursor reservoirs of the atomizing compartments are divided in two or more subsets of precursor reservoirs, e.g. 2, 3, 4, 5 or more subsets, whereby the precursor reservoirs of each subset are fluidly connected to one another. This is particularly preferred if use is made of two or more different precursors or precursor mixtures. This is also particularly preferred in combination with a compartmentalized aerosol channel as discussed here above.

In an embodiment, the aerosol channel comprises flow-guiding fans for assisting the flow in the aerosol channel and/or for aiding in selecting droplet size and/or droplet amount in the aerosol.

In an embodiment, the aerosol generating device comprises a nozzle attached to the nozzle outlet. Preferably, the nozzle is detachably attached for allowing easy maintenance and replacement. The nozzle may comprise two or more sections for guiding the precursor-comprising aerosol flow from the nozzle outlet to a plasma coating apparatus, preferably said two or more sections in the nozzle corresponding to sections in the aerosol channel. In an embodiment, the nozzle comprises a separate section for each of the atomizing compartments, preferably in combination with the aerosol channel comprising comprises a separate section for each of the atomizing compartments extending from at least the fluid flow channel outlet up to the nozzle outlet. This allows to keep the aerosol flows from each compartment separate up to the plasma coating apparatus. Such compartmentalization of the nozzle may also be used to better control droplet orientations and/or the flow of the aerosol.

In general, all forms of compartmentalization provided above enable to have various injection rates for various precursors and better control of the resulting droplet mixture of precursors in the aerosol provided to the plasma coating apparatus.

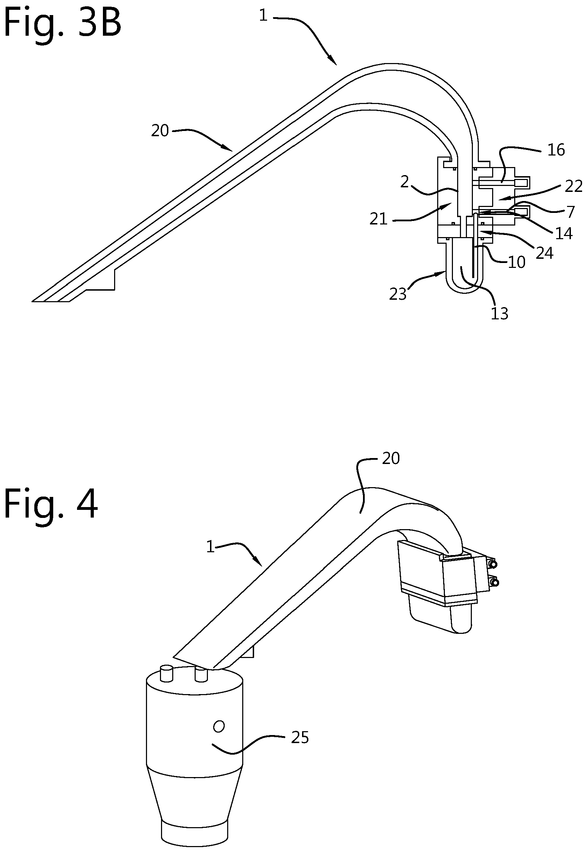

Figures 3A and 3B illustrate the aerosol generating device comprising a nozzle (20) as disclosed above. The figures illustrate how the device may preferably comprise a body (21) which comprises the aerosol droplet separator (2) and a manifold (22) comprising the dilution flow channels (16), fluid flow channels (7), the droplet introduction means (14) and optionally a portion of the precursor channels of the set of atomizing compartments. The manifold can be attached to the body, preferably detachably attached by e.g. bolts or screws. The device may also comprise a reservoir piece (23) comprising the precursor reservoirs (13) and at least a portion of the precursor channels (10). The reservoir piece is attached to the body, preferably detachably attached, optionally with a spacer part (24) in between the body and the reservoir piece, said spacer part allowing to regulate the distance between the reservoir piece and the body.

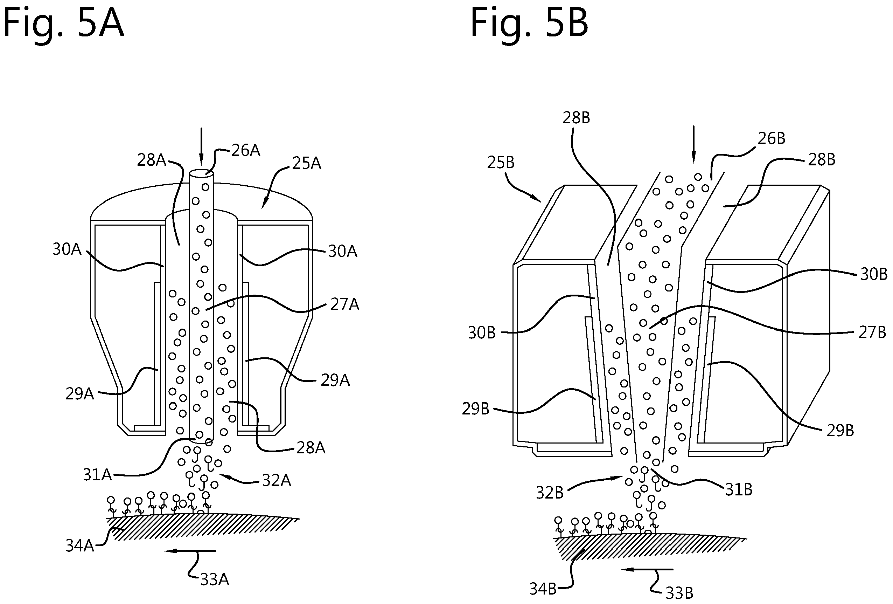

Figure 4 illustrates how the aerosol generating device (1) can coupled to a plasma coating apparatus (25) using a nozzle. Figures 5A and 5B illustrate two possible embodiments (25A, 25B) of a plasma coating device which can be used. Hereby, the plasma coating apparatus comprises an aerosol inlet (26A, 26B) of an aerosol duct (27A, 27B) to which the nozzle of fig. 4 can be coupled. The plasma coating apparatus preferably comprises a plasma duct (28A, 28B) through which a plasma gas can be made to flow (the flows go from top to bottom in the figure, but the orientation can be changed). The plasma gas can be ignited, thereby forming a plasma in the plasma duct. The ignition can be achieved by a set of electrodes (29A, 29B) which are preferably separated from the plasma duct by a dielectric (30A, 30B). The aerosol is then injected (31A, 31B) into the plasma, preferably in the plasma afterglow (32A, 32B), which is a region where no plasma is directly induced but which still contains excited species such as ionized molecules or radicals which were directly or indirectly obtained from the plasma or the interactions within the plasma or between the plasma and the aerosol. As such a precursor-comprising plasma is formed, which can be used to coat a substrate (34A, 34B) which can for instance be made to move (33A, 33B) underneath the flow of precursor-comprising plasma.

## Claims

1. An aerosol generating device for generating a precursor-comprising aerosol flow for a plasma coating process, the aerosol generating device comprising an aerosol droplet separator and a set of atomizing compartments,
whereby the aerosol droplet separator comprises a nozzle outlet, a precursor recycling outlet and an aerosol channel therebetween, and
whereby each atomizing compartment comprises:
- a fluid flow channel comprising an atomizer gas flow inlet and an atomizer gas flow outlet fluidly connected to the aerosol channel;
- a precursor channel comprising a precursor channel inlet and a precursor channel outlet, the precursor channel outlet fluidly connected to the fluid flow channel for introducing precursor droplets into a gas flow in the fluid flow channel;
- a precursor reservoir for a liquid precursor the precursor reservoir in fluid connection with the precursor channel inlet;
- a droplet introduction means located at or near the precursor channel outlet for introducing liquid precursor droplets from the precursor reservoir via the precursor channel into a gas flow in the fluid flow channel;
- a dilution flow channel separated from the fluid flow channel, the dilution flow channel comprising a dilution flow inlet and a dilution flow outlet fluidly connected to the aerosol channel,
whereby for each atomizing compartment, the dilution flow outlet is located between the atomizer gas flow outlet and the nozzle outlet of the aerosol droplet separator.

2. An aerosol generating device according to claim 1, wherein the dilution flow channel is oriented essentially parallel to the fluid flow channel.

3. An aerosol generating device according to any of the preceding claims, wherein the aerosol channel is oriented essentially perpendicular to the fluid flow channel and/or the dilution flow channel.

4. An aerosol generating device according to any of the preceding claims, wherein the dilution flow outlet is located within an inter-outlet distance of 10cm or less from the atomizer gas flow outlet, such as 10 cm, 9 cm, 8 cm, 7 cm, 6 cm, 5 cm, 4 cm, 3 cm, 2cm, 1cm or any value therebetween or below.

5. An aerosol generating device according to any of the preceding claims, wherein the atomizer gas flow inlet is connected to an atomizing gas supply, wherein the dilution flow inlet is connected to a dilution gas supply and/or wherein the precursor reservoir comprises a liquid precursor.

6. An aerosol generating device according to any of the preceding claims, wherein the droplet introduction means comprises a Venturi tube located in the fluid flow channel at the location of the precursor channel outlet.

7. An aerosol generating device according to any of the preceding claims, wherein the set of atomizing compartments comprises more than one atomizing compartment, whereby the atomizer gas flow outlets of each of the atomizing compartments of the set are fluidly connected to the aerosol channel.

8. An aerosol generating device according to claim 7, wherein the multiple atomizing compartments are arranged next to one another thereby forming a row of atomizing compartments.

9. An aerosol generating device according to any of the preceding claims, wherein each atomizing component comprises an atomizer control system for controlling the atomizing parameters, said atomizing parameters comprising any or any of the following:
- flow of plasma gas through the fluid flow channel;
- temperature of the plasma gas in the fluid flow channel;
- temperature of the precursor in the reservoir and/or in the precursor channel;
- pressure in the precursor reservoir and/or precursor channel.

10. An aerosol generating device according to any of the preceding claims, wherein the aerosol channel is compartmentalized and/or wherein the precursor reservoirs of two or more atomizing compartments are fluidly connected.

11. An aerosol generating device according to any of the preceding claims, wherein the aerosol channel comprises flow-guiding fans for assisting the flow in the aerosol channel and/or for aiding in selecting droplet size and/or droplet amount in the aerosol.

12. An aerosol generating device according to any of the preceding claims, wherein the aerosol generating device comprises a nozzle attached to the nozzle outlet.

13. A plasma coating system comprising the aerosol generating device according to any of the preceding claims and a plasma coating apparatus, whereby the aerosol channel of the aerosol generating device is fluidly connected to a precursor input of the plasma coating apparatus.

14. An aerosol generating method for generating a precursor-comprising aerosol flow for a plasma coating process, the method comprising the steps of:
- providing an atomizer gas flow in a fluid flow channel;
- introducing droplets of a precursor from a precursor reservoir in said atomizer gas flow, thereby creating a precursor-comprising aerosol flow in the fluid flow channel;
- guiding said aerosol flow to an aerosol channel via a fluid flow channel outlet;
- guiding a dilution flow into said aerosol channel via a dilution flow outlet, thereby hydrodynamically regulating size and/or quantity of droplets in the aerosol flow and leading to precursor residue separated from the aerosol flow;
- guiding the aerosol flow in the aerosol channel to a nozzle outlet and guiding the precursor residue to a precursor recycling outlet.

15. An aerosol generating method according to claim 14, whereby the precursor-comprising aerosol flow is guided to a plasma coating apparatus via a nozzle.
